# EUROPEAN PATENT APPLICATION

(11) **EP 4 632 415 A1**
(43) Date of publication of application: **15.10.2025**
(21) Application number: 24169225.0
(22) Date of filing: 09.04.2024
(51) Int. Cl.: G01R 31/64, H02J 3/18

(54) **IMPROVED FAULT IDENTIFICATION AND LOCATION FOR Y-CONNECTED SHUNT CAPACITOR BANKS (SCB) WITH VOLTAGE DIFFERENTIAL PROTECTION**

(71) Applicant: ABB Schweiz AG, 5400 Baden (CH)
(72) Inventor: VALSAN, Simi, 683108 Aluva (IN); GUPTA, Arinjai, 560093 Bengaluru (IN)
(74) Representative: Zimmermann & Partner Patentanwälte mbB

(57) **Abstract**

An apparatus for identifying a simultaneous fault in a shunt capacitor system connected to a bus and comprising at least one tap point. The apparatus comprises an interface configured to receive a plurality of voltage measurements, the plurality of voltage measurements comprising one combination of a first voltage measurement and a second voltage measurement: a first voltage measurement at a first tap point of a shunt capacitor bank; and a second voltage measurement at the bus, wherein the shunt capacitor system is a single y-connected shunt capacitor bank comprising the shunt capacitor bank; and a first voltage measurement at a first tap point of a first y-connected branch; and a second voltage measurement at a second tap point of a second y-connected branch, wherein the shunt capacitor system is a double y-connected shunt capacitor bank comprising the first y-connected branch and the second y-connected branch; and, a fault identifier configured to identify a simultaneous fault of the shunt capacitor system based upon a temporal evolution of the first voltage measurement and of the second voltage measurement.

## Description

### TECHNICAL FIELD

Embodiments of the present disclosure relate to an apparatus for identifying a simultaneous fault in a shunt capacitor system connected to a bus and comprising at least one tap point. Further embodiments relate to a method for identifying a simultaneous fault in a shunt capacitor system connected to a bus and comprising at least one tap point.

### BACKGROUND

In an electrical power system, a shunt capacitor bank (SCB) is employed to improve the power factor of the electrical power system and to reduce line losses. In particular, the shunt capacitor bank, which is formed from a plurality of capacitors electrically connected in parallel with a load of the electrical power system, may correct the power factor of loads with a low power factor. Further, the SCB may balance a voltage level during load variations.

During operation of the SCB, capacitor faults may arise. For a safe and reliable operation of the SCB, a reliable identification of the presence and location of a faulty capacitor is advantageous. To provide such a fault identification a plurality of different protection concepts are available. In particular, for single y-connected SCB, bus and tap voltages for each phase may be measured and the bus voltages measured may be scaled to account for the tap position. For double y-connected SCBs, tap voltages are measured for both branches of the SCB, with the taps being at identical positions of the respective branch. From a voltage difference between the tap voltage and the bus voltage of the same phase for the single y-connected SCB or between the tap voltages of both branches for the double y-connected SCB, faults are identified and located.

However, for some patterns of faults, in particular for simultaneous faults, those faults may not be detectable from merely measuring the voltage difference as discussed above. Further, the location of a fault as determined by such a method may have some ambiguity, increasing the time required to locate the defective capacitor in the field.

Thus, an apparatus for and a method of improving the identification of faults, in particular of simultaneous faults for y-connected shunt capacitor systems with voltage differential protection might be desirable. Further, it might be desired to improve the localization of faults in y-connected shunt capacitor systems and to count a number of distinct faults.

### DISCLOSURE OF THE INVENTION

In the view of the foregoing, the present disclosure is directed to an apparatus for identifying a simultaneous fault in a shunt capacitor system connected to a bus and comprising at least one tap point, and a method of identifying a simultaneous fault in a shunt capacitor system connected to a bus and comprising at least one tap point.

According to an aspect of the present invention, an apparatus for identifying a simultaneous fault in a shunt capacitor system connected to a bus and comprising at least one tap point, is provided. The apparatus comprises an interface configured to receive a plurality of voltage measurements, the plurality of voltage measurements comprising one combination of a first voltage measurement and a second voltage measurement: a first voltage measurement at a first tap point of a shunt capacitor bank; and a second voltage measurement at the bus, wherein the shunt capacitor system is a single y-connected shunt capacitor bank comprising the shunt capacitor bank; and a first voltage measurement at a first tap point of a first y-connected branch; and a second voltage measurement at a second tap point of a second y-connected branch, wherein the shunt capacitor system is a double y-connected shunt capacitor bank comprising the first y-connected branch and the second y-connected branch. The apparatus further comprises a fault identifier configured to identify a simultaneous fault of the shunt capacitor system based upon a temporal evolution of the first voltage measurement and of the second voltage measurement.

According to another aspect, a method of identifying a simultaneous fault in a shunt capacitor system connected to a bus and comprising at least one tap point is provided. The method comprises obtaining a plurality of voltage measurements, the plurality of voltage measurements comprising one combination of a first voltage measurement and a second voltage measurement: a first voltage measurement at a first tap point of a shunt capacitor bank; and a second voltage measurement at the bus, wherein the shunt capacitor system is a single y-connected shunt capacitor bank comprising the shunt capacitor bank; and a first voltage measurement at a first tap point of a first y-connected branch; and a second voltage measurement at a second tap point of a second y-connected branch, wherein the shunt capacitor system is a double y-connected shunt capacitor bank comprising the first y-connected branch and the second y-connected branch. The method further comprises identifying a simultaneous fault of the shunt capacitor system based upon a temporal evolution of the first voltage measurement and of the second voltage measurement.

According to some embodiments, the shunt capacitor system with at least one shunt capacitor bank, is connected to a bus, exemplarily a busbar, and comprises at least one tap point. The at least one tap point is configured to allow a voltage measurement at a position within the shunt capacitor system. In particular, the voltage measurement may comprise a phase voltage measurement for three phases of the voltage.

In some embodiments, in particular for a single y-connected SCB, a first voltage measurement is conducted at a first tap point and a second voltage measurement is conducted at the bus, measuring a bus voltage.

In some embodiments, in particular for a double y-connected SCB, with at least two SCB being independently connected to the bar in parallel, the first tap point is configured to allow a first voltage measurement of a first y-connected branch of the double y-connected SCB, and a second tap point is configured to allow a second voltage measurement of a second y-connected branch of the double y-connected SCB. Preferably, the first tap point and the second tap point are located at substantially identical positions on both branches of the double y-connected SCB. In particular, the first and second tap positions may be located substantially at the midpoint of the respective branches.

The plurality of voltage measurements, comprising the first voltage measurement and the second voltage measurement, is received via an interface of the apparatus. Receiving the plurality of voltage measurements may comprise receiving an analog or digital representation of the plurality of voltage measurements. According to some embodiments, receiving the plurality of voltage measurements may comprise receiving time-indicated voltage measurements. In particular, for each voltage measurement, a time indication indicating a point in time at which the voltage measurement is conducted may be received.

Receiving the plurality of voltage measurements may comprise receiving the voltage measurements at regular points in time or continuously. In particular, receiving the plurality of voltage measurements may comprise receiving the voltage measurements at least every 100 µs, every 200 µs, every 400 µs, every 500 µs, every 800 µs, or every 1 ms. Exemplarily, a 1600 Hz sampling may be employed, leading to a voltage measurement received every 625 µs for a 50 Hz system. Receiving the plurality of voltage measurements may comprise storing the plurality of voltage measurements, at least temporarily. This particularly allows to compare voltage measurements within a time range.

In some embodiments, the apparatus may add the time indication to the voltage measurements received. In particular the time indication may comprise the time at which the voltage measurements are received by the interface.

The fault identifier is configured to identify a simultaneous fault of the shunt capacitor system based on a temporal evolution of the first voltage measurement and of the second voltage measurement. In particular, the fault identifier can be configured to determine a plurality of moving sums of a second harmonic component and/or a DC component of the plurality of voltage measurements. In some embodiments, for each of the plurality of voltage measurements, in particular for each phase voltage measurement of the plurality of voltage measurements, a moving sum is determined. The plurality of moving sums is determined over a defined number of power cycles of the voltage or over a predefined period of time. In particular, the plurality of moving sums may be determined over one power cycle of the voltage.

In some embodiments, for at least one, in particular for each, of the plurality of moving sums, a respective threshold is generated. The respective threshold defines a reference value of the respective moving sum of the respective voltage measurement. The respective threshold may be generated over the first X power cycles, with X being an integer of at most 10. In particular, the respective threshold may be generated over the first 2, 3, 4, 5, 6, 8 or 10 power cycles, preferably over the first 4 power cycles. A threshold may be generated and/or updated upon starting of the apparatus, upon a user request and/or upon a user-defined event. In some embodiments, the threshold may be generated when the SCB is in a known substantially fault-free (healthy) state.

According to some embodiments, the fault identifier determines a plurality of difference voltages between respective phases of the first voltage measurement and the second voltage measurement. In particular, the fault identifier subtracts a first voltage measurement value of the first voltage measurement from a second voltage measurement value of the second voltage measurement, or vice versa. In some embodiments the fault identifier may determine the plurality of difference voltages based upon an averaged first voltage measurement and/or an averaged second voltage measurement. The fault identifier monitors the plurality of difference voltages and identifies a fault based upon the plurality of difference voltages. In particular, in a healthy (substantially fault-free) state of the SCB, the plurality of the difference voltages are substantially zero. If a fault occurs, at least one absolute value of the plurality of difference voltages is substantially larger than zero.

According to some embodiments, the fault identifier continuously monitors the plurality of the moving sums. Continuously monitoring may comprise monitoring at regular time intervals, in particular time intervals substantially shorter, exemplarily at least ten times shorter, than the duration of a power cycle.

If one of the plurality of moving sums exceeds the respective adaptive threshold for at most one, two, three, or four power cycles, preferably for two power cycles, a first fault indication is triggered. The first fault indication may comprise a respective time indication. Limiting the triggering of the first fault indication to events where one of the plurality of moving sums exceeds the respective adaptive threshold for a limited number of power cycles may advantageously avoid triggering a first fault indication for an external system disturbance, which may particularly exhibit changes of the moving sum exceeding 5 power cycles.

The fault identifier may identify a multiple branch simultaneous fault, in particular for a double y-connected SCB, if a second fault indication is triggered within a predefined period of time, in particular a second fault indication for the same phase as the first fault indication. The predefined period of time may be at least 10 ms, at least 50 ms, at least 100 ms and at most 200 ms, at most 500 ms or at most 1s. In typical embodiments, the predefined period of time may be 100 ms.

The fault identifier may identify a same branch simultaneous fault if one of the moving sums exceeds the respective threshold while a first difference voltage and a subsequent second difference voltage are present, wherein the subsequent second difference voltage has a different sign than the first difference voltage. In particular, the subsequent second difference voltage has substantially the same amplitude of the first difference voltage, but a different sign than the first difference voltage. Exemplarily, the amplitude of the subsequent second difference voltage may at least be 90 %, 95 % or 99 % and at most be 101 %, 105 % or 110% of the amplitude of the first difference voltage. In other words, the second difference voltage substantially nullifies the first difference voltage.

The fault identifier may count a number of faults based on the plurality of moving sums, in particular including simultaneous faults as identified by the fault identifier. The fault identifier may count simultaneous faults and isolated faults separately or may count the overall number of faults under consideration of the simultaneous faults.

In some embodiments, the fault identifier is configured to identify a location of a fault based upon a sign of one of the plurality of difference voltages, a sign of a change of the amplitude of the first voltage measurement and of the amplitude of the second voltage measurement with respect to a past point in time, and a location or a presence of a fuse. In particular, the fault identifier may receive an information on whether the SCB comprises an internal fuse, an external fuse or is fuseless.

The change of the amplitude of the first voltage measurement with respect to a past point in time may also be described as a first delta voltage. The change of the amplitude of the second voltage measurement with respect to a past point in time may also be described as a second delta voltage.

In some embodiments, the past point in time may be one, two, three or four power cycles, preferably two power cycles, prior to the present point of time. The change of the amplitude of the first voltage measurement and of the amplitude of the second voltage measurement with respect to a past point in time can be calculated as the amplitude of the respective voltage measurement at the past point in time subtracted from the amplitude of the respective voltage measurement at the present point of time.

For a double y-connected SCB, the fault identifier determines a sign of the plurality of difference voltages, the first delta voltage and the second delta voltage and the fuse location or the fuse presence.

In particular, for an absolute value of the voltage of the first voltage measurement exceeding an absolute value of the voltage of the second voltage measurement, the fault identifier locates the fault in the first y-connected branch of the double y-connected SCB, if the first delta voltage and the second delta voltage are positive; in other words, if the absolute value of the first voltage measurement and of the second voltage measurement increases with respect to the respective voltage measurement at the past point in time. The fault identifier locates the fault below the first tap, in other words towards the ground, for an internal fuse and above the first tap, in other words towards the bus, for a fuseless configuration or an external fuse.

In particular, for an absolute value of the voltage of the first voltage measurement exceeding an absolute value of the voltage of the second voltage measurement, the fault identifier locates the fault in the second y-connected branch of the double y-connected SCB, if the first delta voltage and the second delta voltage are negative; in other words, if the absolute value of the first voltage measurement and of the second voltage measurement decreases with respect to the respective voltage measurement at the past point in time. The fault identifier locates the fault above the second tap, in other words towards the bus, for an internal fuse and below the second tap, in other words towards the ground, for a fuseless configuration or an external fuse.

In particular, for an absolute value of the voltage of the second voltage measurement exceeding an absolute value of the voltage of the first voltage measurement, the fault identifier locates the fault in the second y-connected branch of the double y-connected SCB, if the first delta voltage and the second delta voltage are positive; in other words, if the absolute value of the first voltage measurement and of the second voltage measurement increases with respect to the respective voltage measurement at the past point in time. The fault identifier locates the fault below the second tap, in other words towards the ground, for an internal fuse and above the second tap, in other words towards the bus, for a fuseless configuration or an external fuse.

In particular, for an absolute value of the voltage of the second voltage measurement exceeding an absolute value of the voltage of the first voltage measurement, the fault identifier locates the fault in the first y-connected branch of the double y-connected SCB, if the first delta voltage and the second delta voltage are negative; in other words, if the absolute value of the first voltage measurement and of the second voltage measurement decreases with respect to the respective voltage measurement at the past point in time. The fault identifier locates the fault above the first tap, in other words towards the bus, for an internal fuse and below the first tap, in other words towards the ground, for a fuseless configuration or an external fuse.

If the fault identifier identifies a multiple branch simultaneous fault, the fault identifier determines the first delta voltage and the second delta voltage and fuse location or fuse presence.

In particular, for the first delta voltage and the second delta voltage being positive and the SCB having an internal fuse, the fault identifier locates the simultaneous fault below the first tap and below the second tap, in other words between the ground and the first tap and between the ground and the second tap.

In particular, for the first delta voltage and the second delta voltage being positive and the SCB having an external fuse or being fuseless, the fault identifier locates the simultaneous fault above the first tap and above the second tap, in other words between the bus and the first tap and between the bus and the second tap.

In particular, for the first delta voltage and the second delta voltage being negative and the SCB having an internal fuse, the fault identifier locates the simultaneous fault above the first tap and above the second tap, in other words between the bus and the first tap and between the bus and the second tap.

In particular, for the first delta voltage and the second delta voltage being negative and the SCB having an external fuse or being fuseless, the fault identifier locates the simultaneous fault below the first tap and below the second tap, in other words between the ground and the first tap and between the ground and the second tap.

If the fault identifier identifies a same branch simultaneous fault, the fault identifier locates the same branch simultaneous fault above and below the tap of the respective branch. Exemplarily, if the fault identifier identifies the same branch simultaneous fault to be on the first y-connected branch, the fault identifier locates the simultaneous fault above and below the first tap. If the fault identifier identifies the same branch simultaneous fault to be on the second y-connected branch, the fault identifier locates the simultaneous fault above and below the second tap.

Employing the first and second delta voltage, and thereby considering the temporal evolution of the voltage measurements, advantageously allows to locate positions of a fault more precisely. Providing a more precise fault location may reduce maintenance times and enable an evaluation of the potential impact of a fault.

Embodiments of the present disclosure advantageously allow to identify and locate faults in SCB more precisely. In particular, previously undetectable simultaneous faults may be recognized and located. The present disclosure allows to identify and locate simultaneous faults with minimal additional components. In particular, identifying simultaneous faults improves the reliability and safety of SCB.

### BRIEF DESCRIPTION OF THE DRAWINGS

The accompanying schematic drawings relate to embodiments of the disclosure and are described in the following:
- FIG 1a: an apparatus for identifying a simultaneous fault in a shunt capacitor system comprising a single y-connected capacitor bank according to embodiments described herein;
- FIG 1b: an apparatus for identifying a simultaneous fault in a shunt capacitor system comprising a double y-connected capacitor bank according to embodiments described herein;
- FIG 2: a method of identifying a simultaneous fault in a shunt capacitor system according to embodiments described herein;
- FIG 3: the method of FIG 2 with optional additional features.

### DETAILED DESCRIPTION OF EMBODIMENTS

Reference will now be made in detail to the various embodiments of the disclosure, one or more examples of which are illustrated in the figures. Generally, only the differences with respect to individual embodiments are described. Each example is provided by way of explanation of the disclosure and is not meant as a limitation of the disclosure. Further, features illustrated or described as part of one embodiment can be used on or in conjunction with other embodiments to yield a further embodiment. It is intended that the description includes such modifications and variations.

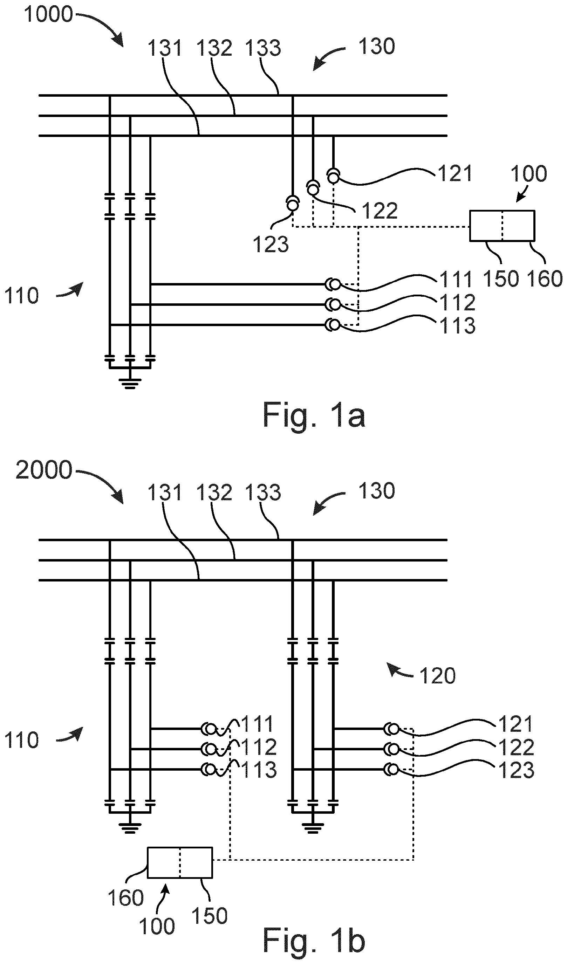

FIG 1a schematically illustrates an apparatus 100 for identifying a simultaneous fault in a shunt capacitor system 1000 comprising a single y-connected shunt capacitor bank 110 according to embodiments described herein. The single y-connected shunt capacitor bank 110 is connected to a bus 130 and comprises a first tap point 111, 112, 113. A first voltage measurement may be performed at the first tap point 111, 112, 113. The bus 130 comprises three conductors 131, 132, 133 for three phases of the voltage. The voltage of the bus 130 can be measured as a second voltage measurement at three bus measurement positions 121, 122, 123 for each of the phases. The apparatus 100 comprises an interface 150 and a fault identifier 160. The interface 150 receives the first voltage measurement performed at the first tap point 111, 112, 113 and the second voltage measurement performed at the bus measurement positions and indicative of the bus voltage. The apparatus 100 further comprises a fault identifier 160 configured to identify a simultaneous fault of the shunt capacitor system based upon a temporal evolution of the first voltage measurement and of the second voltage measurement. The apparatus 100 may be configured to identify a location of a fault and may be configured to count a number of faults.

FIG 1b schematically illustrates an apparatus 100 for identifying a simultaneous fault in a shunt capacitor system 2000 comprising a double y-connected shunt capacitor bank 110, 120 according to embodiments described herein. The shunt capacitor system 2000 comprises a first y-connected branch 110 with a first tap point 111, 112, 113, and a second y-connected branch 120 with a second tap point 121, 122, 123. The first voltage measurement may be performed at the first tap point 111, 112, 113 and the second voltage measurement may be performed at the second tap point 121, 122, 123.

In FIG 1a and FIG 1b, single capacitors schematically shown for the first y-connected branch 110 and the second y-connected branch 120, may comprise a plurality of capacitor banks. In particular, each of the capacitors shown in FIG 1a and FIG 1b may represent a plurality of capacitors, electrically connected in series and/or in parallel. The first tap point 111, 112, 113 and the second tap point 121, 122, 123 are substantially at the same position of the respective branch of the shunt capacitor system 2000. The fault identifier 160 may identify a location of the fault with respect to the first tap point 111, 112, 113, and/or the second tap point 121, 122, 123. In particular, the fault identifier may locate the fault to be below or above the respective tap point. A fault above the tap point is located between the bus 130 and the tap point. A fault below the tap point is located between the ground and the tap point.

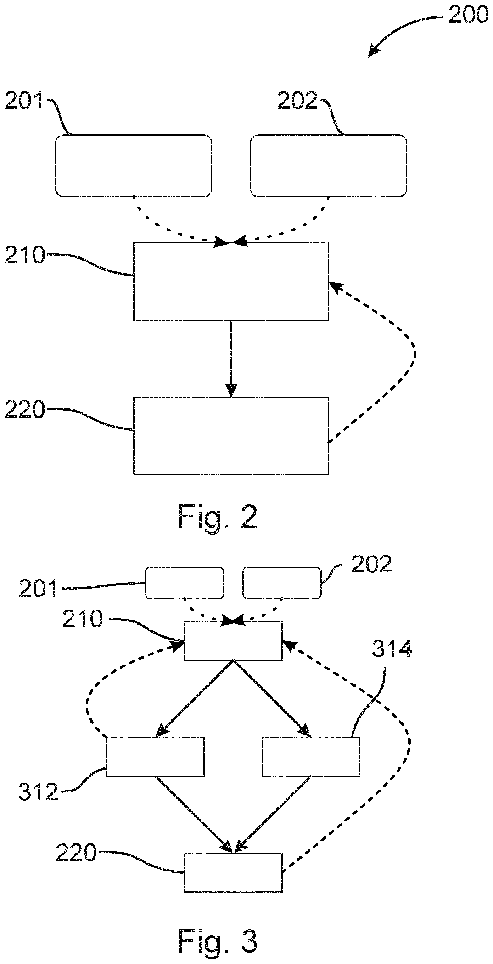

In FIG 2, a method 200 of identifying a simultaneous fault in a shunt capacitor system, according to embodiments described herein, is schematically depicted. The method comprises receiving 210 a first voltage measurement 201 and a second voltage measurement 202. The first voltage measurement 201 may be conducted at a first tap point of a shunt capacitor bank connected to a bus. The second voltage measurement 202 is a bus voltage measurement for a single y-connected shunt capacitor bank. For a double y-connected shunt capacitor bank, the second voltage measurement 202 is conducted at a second tap point of a second shunt capacitor bank. Each of the voltage measurements may comprise a time indication, or receiving 210 comprises adding the time indication. Receiving 210 the first voltage measurement 201 and the second voltage measurement 202 may comprise storing the first voltage measurement 201 and the second voltage measurement 202, in particular in combination with the time indication.

From the first voltage measurement 201 and the second voltage measurement 202, a simultaneous fault is identified 220. In particular identifying 220 a simultaneous fault may comprises monitoring a temporal evolution of the first voltage measurement and the second measurement. The method 200 may be conducted continuously with receiving 210 a plurality of voltage measurements and identifying 220 a simultaneous fault being conducted iteratively.

In FIG 3, the method 200 is shown with additional details. In particular, the method 200 further comprises calculating 312 a plurality of moving sums of the plurality of voltage measurements. The method may comprise generating a respective threshold for each of the plurality of moving sums in the first X power cycles. The respective threshold may be stored, in particular by the interface to be accessed by the fault identifier, as shown in Fig. 1a and 1b. Further, the method comprises determining 314 a plurality of difference voltages between respective phases of the first voltage measurement and the second voltage measurement. A simultaneous fault is identified 220 based upon the plurality of difference voltages determined 314 and/or the plurality of moving sums calculated 312.

## Claims

1. An apparatus (100) for identifying a simultaneous fault in a shunt capacitor system (1000, 2000) connected to a bus (130) and comprising at least one tap point (111, 112, 113, 121, 122, 123), the apparatus comprising:
an interface (150) configured to receive a plurality of voltage measurements, the plurality of voltage measurements comprising one combination of a first voltage measurement and a second voltage measurement:
a first voltage measurement at a first tap point (111, 112, 113) of a shunt capacitor bank; and a second voltage measurement at the bus, wherein the shunt capacitor system is a single y-connected shunt capacitor bank comprising the shunt capacitor bank; and
a first voltage measurement at a first tap point of a first y-connected branch; and a second voltage measurement at a second tap point (121, 122, 123) of a second y-connected branch, wherein the shunt capacitor system is a double y-connected shunt capacitor bank comprising the first y-connected branch and the second y-connected branch; and,
a fault identifier (160) configured to identify a simultaneous fault of the shunt capacitor system based upon a temporal evolution of the first voltage measurement and of the second voltage measurement.

2. The apparatus of claim 1, wherein the fault identifier is configured to determine a plurality of moving sums of a second harmonic component and/or a DC component of the plurality of voltage measurements and wherein the fault identifier is configured to identify the simultaneous fault from a temporal evolution of the plurality of moving sums of the second harmonic component and/or the DC component of the plurality of voltage measurements.

3. The apparatus of claim 2, wherein the plurality of moving sums is generated over one power cycle of the voltage.

4. The apparatus of any of claims 2-3, wherein a respective threshold is generated for each of the plurality of moving sums in the first X power cycles, wherein X is an integer below 10.

5. The apparatus of any of the preceding claims, wherein the fault identifier determines a plurality of difference voltages between respective phases of the first voltage measurement and the second voltage measurement; and wherein the fault identifier identifies a same branch simultaneous fault based upon the plurality of difference voltages.

6. The apparatus of claim 5, wherein the same branch simultaneous fault is identified if one of the moving sums exceeds a respective threshold while a first difference voltage and a subsequent second difference voltage are present, wherein the subsequent second difference voltage has a different sign than the first difference voltage, in particular wherein the first difference voltage and the subsequent second difference voltage substantially nullify each other.

7. The apparatus of any of claims 2-5, wherein a multiple branch simultaneous fault is identified if at least two of the plurality of moving sums of respective phases exceed the respective threshold within a predefined period of time.

8. The apparatus of any of claims 5-7, wherein the fault identifier is configured to identify a location of a fault based upon a sign of one of the plurality of difference voltages, a sign of a change of the amplitude of the first voltage measurement and of the amplitude of the second voltage measurement with respect to a past point in time and a location or a presence of a fuse.

9. The apparatus of any of claims 2-8, wherein the fault identifier is configured to count a number of faults based on the plurality of moving sums.

10. A method (200) of identifying a simultaneous fault in a shunt capacitor system connected to a bus and comprising at least one tap point, the method comprising:
receiving (210) a plurality of voltage measurements (201, 202), the plurality of voltage measurements comprising one combination of a first voltage measurement (201) and a second voltage measurement (202):
a first voltage measurement at a first tap point of a shunt capacitor bank; and a second voltage measurement at the bus, wherein the shunt capacitor system is a single y-connected shunt capacitor bank comprising the shunt capacitor bank; and
a first voltage measurement at a first tap point of a first y-connected branch; and a second voltage measurement at a second tap point of a second y-connected branch, wherein the shunt capacitor system is a double y-connected shunt capacitor bank comprising the first y-connected branch and the second y-connected branch; and
identifying (220) a simultaneous fault of the shunt capacitor system based upon a temporal evolution of the first voltage measurement and of the second voltage measurement.

11. The method of claim 10, further comprising calculating (312) a plurality of moving sums of the second harmonic component or the DC component of each of the plurality of voltage measurements, wherein identifying a simultaneous fault is based upon a temporal evolution of the second harmonic component and/or the DC component of the plurality of voltage measurements.

12. The method of claim 11, further comprising generating a respective threshold for each of the plurality of moving sums in the first X power cycles, wherein X is an integer below 10.

13. The method of any of claims 10 to 12, further comprising determining (314) a plurality of difference voltages between respective phases of the first voltage measurement and the second voltage measurement, wherein identifying a same branch simultaneous fault is based upon the plurality of difference voltages, particularly wherein the same branch simultaneous fault is identified if one of the moving sums exceeds the respective threshold while a first difference voltage and a subsequent second difference voltage are present, wherein the subsequent second difference voltage has a different sign than the first difference voltage, more particularly wherein the first difference voltage and the subsequent second difference voltage substantially nullify each other.

14. The method of any of claims 11 to 12, wherein a multiple branch simultaneous fault is identified if at least two of the plurality of moving sums of respective phases exceed the respective threshold within a predefined period of time.

15. The method of any of claims 12 to 14, further comprising
identifying a location of a fault based upon a sign of one of the plurality of difference voltages, a sign of a change of the amplitude of the first voltage measurement and of the amplitude of the second voltage measurement with respect to a past point in time and a location or a presence of a fuse.
